# EUROPEAN PATENT SPECIFICATION

(11) **EP 0 478 123 B1**
(45) Date of publication and mention of the grant of the patent: **25.09.1996**
(21) Application number: 91306667.6
(22) Date of filing: 22.07.1991
(51) Int. Cl.: H01L 27/02

(54) **Low voltage device in a high voltage substrate**
Niederspannungsbauelement in einem Substrat für hohe Spannungen
Dispositif à tension faible dans un substrat à haute tension

(30) Priority: 28.09.1990 US 590277
(43) Date of publication of application: 01.04.1992
(73) Proprietor: ACTEL CORPORATION, Sunnyvale California 94086 (US)
(72) Inventor: Ahrens, Michael G., Sunnyvale, CA 94086 (US); Galbraith, Douglas C., Fremont, CA 94536 (US); Eltoukhy, Abdelshafy A., San Jose, CA 95136 (US)
(74) Representative: Senior, Alan Murray

(56) References cited:
- EP-A- 114 491
- EP-A- 0 319 047
- FR-A- 2 367 352
- US-A- 3 916 430
- IEDM TECHNICAL DIGEST 11-14 December 1988, pages 580-583, San Francisco, CA, US; R.N. ROUNTREE: "ESD Protection for Submicron CMOS Circuits Issues and Solutions"

## Description

### BACKGROUND OF THE INVENTION

### 1. Field Of The Invention

The present invention relates to integrated circuit technology and integrated circuit fabrication techniques. More particularly, the present invention relates to incorporation of a low voltage MOS device in a high voltage substrate or well.

### 2. The Prior Art

The design of MOSFET and MESFET circuits sometimes requires the inclusion of both low voltage and high voltage circuits on the same chip. Inclusion of both types of circuits is sometimes needed for aspects of the operation of a single chip, such as low voltage circuits for reading a PROM and high voltage circuits for programming the PROM. The design of MOSFET or MESFET circuits which include an interface between low voltage circuits and high voltage circuits traditionally incorporates two separate wells, one well for low voltage devices and a second well for high voltage devices. These separate wells are usually surrounded by double guard rings to suppress destructive latch up. The double wells and their attendant guard rings constitute a considerable layout area penalty, especially for repetitive circuits such as address or decoder level shifters.

As integrated circuit technology matures, and as circuit and layout designers strive to increase the density of integrated circuits the provision of separate wells and their attendant guard rings for high and low voltage devices creates a limitation on achievable circuit density on an integrated circuit chip.

US 3,916,430 discloses an integrated circuit containing high and low voltage transistors each of which has its source connected to the same potential as its well or substrate.

According to the present invention, there is provided a semiconductor structure including:
a semiconductor substrate of a first conductivity type;
a well structure of a second conductivity type formed in said substrate;
a first low voltage MOS transistor in said well including spaced-apart low voltage transistor source and drain regions of said first conductivity type in said well forming a first transistor channel region therebetween, a first transistor gate disposed above said first transistor channel region and separated therefrom by a first transistor gate dielectric having a first thickness, said low voltage transistor source region being connected to a source of low voltage;
a second high voltage transistor in said well including spaced-apart high voltage source and drain regions of said first conductivity type in said well forming a second transistor channel therebetween, a second transistor gate disposed above said second transistor channel region and separated therefrom by a second transistor gate dielectric having a second thickness which is greater than the thickness of said first transistor gate dielectric, said high voltage source region being connected to a source of high voltage;
first and second contact diffusions of said second conductivity type located at the edge of said well and connected to said source of high voltage.

The present invention will be further described hereinafter with reference to the following description of an exemplary embodiment and the accompanying drawings, in which:

FIG. 1 is a cross sectional view of a semiconductor structure according to a presently preferred embodiment of the invention.

FIG. 2 is an equivalent schematic diagram of the structure depicted in FIG. 1.

FIG. 3 is an enlarged cross sectional view of a portion of the semiconductor structure of FIG. 1, showing the operation of the invention.

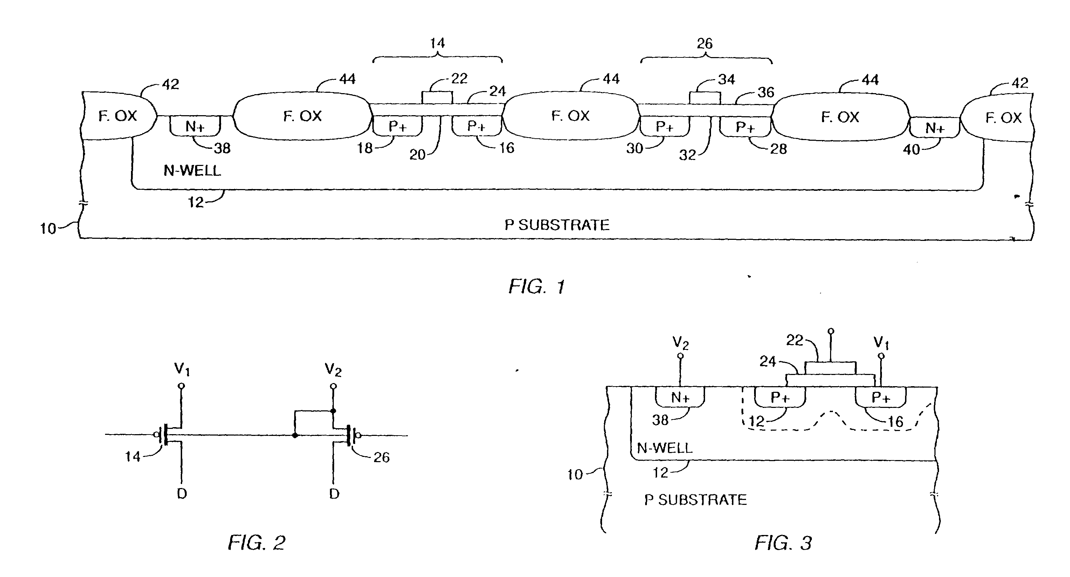

Referring first to FIG. 1, a semiconductor substrate 10 of a first conductivity type is shown to contain a well 12 of a second conductivity type. For purposes of discussing FIG. 1, the substrate 10 will be assumed to be a p-type substrate and the well 12 will be assumed to be an n-well, although those of ordinary skill in the art will readily recognize that the present invention could also be realized in an embodiment where a p-well is disposed within an n-type substrate.

A first, low voltage, MOS transistor 14 includes spaced apart source region 16 and drain region 18 disposed in well 12, serving to establish a channel 20 therebetween. Source region 16 and drain region 18 may be formed by well known methods. In a presently preferred embodiment, they are formed simultaneously by ion implantation of boron using a dose of about 5×10¹⁵ atoms/cm³ and an energy of about 30-50 KeV.

A first transistor gate 22 lies above channel 20 between source 16, and drain 18, and is separated therefrom by a first gate dielectric 24. As is well understood by those of ordinary skill in the art, first transistor gate 22 may be a polysilicon gate, formed using conventional technology. In a presently preferred embodiment, first transistor gate 22 is polysilicon doped with phosphorus to a sheet resistance of about 25-35 Ω/□.

First gate dielectric 24 may be a layer of thermally grown silicon dioxide as is well understood in the art. The thickness of first gate dielectric 24 will depend on the voltage which first, low voltage, MOS transistor 14 is expected to withstand. In the example to be discussed herein, first, low voltage, MOS transistor 14 is designed to withstand about 10 volts, and first gate dielectric should therefore be about 20-50 nm (200-500 Å) thick.

A second, high voltage, MOS transistor 26 includes spaced apart source region 28 and drain region 30 disposed in well 12, serving to establish a channel 32 therebetween. Source region 28 and drain region 30 may be formed by well known methods. In a presently preferred embodiment, they are formed simultaneously by ion implantation of boron using a dose of about 5×10¹⁵ atoms/cm³ and an energy of about 30-50 KeV.

A second transistor gate 34 lies above channel 32 between source 28, and drain 30, and is separated therefrom by a second gate dielectric 36. As is well understood by those of ordinary skill in the art, second transistor gate 34 may be a polysilicon gate, formed using conventional technology. In a presently preferred embodiment, second transistor gate 34 is polysilicon doped with phosphorus to a sheet resistance of about 25-35 Ω/□.

Like first gate dielectric 24, second gate dielectric 36 may be a layer of thermally grown silicon dioxide as is well understood in the art. The thickness of second gate dielectric 36 will depend on the voltage which second, high voltage, MOS transistor 26 is expected to withstand. In the example to be discussed herein, second, high voltage, MOS transistor 26 is designed to withstand about 18 volts, and second gate dielectric 36 should therefore be about 40 nm (400 Å) thick. This is a greater thickness than first gate dielectric 24 and, as appreciated by those of ordinary skill in the art, provides a higher breakdown voltage characteristic for high voltage transistor 26.

First and second well contacts 38 and 40, having a conductivity type the same as the conductivity type of well 12, are formed in well 12 close to opposite ones of its edges using known semiconductor fabrication techniques.

Field oxide regions 42 surround the periphery of well 12, and field oxide regions 44 separate the various structures within well 12 as is customary in the semiconductor art.

During normal circuit operation, the gate-to-source voltage of first, low voltage, MOS transistor 14 will normally swing between 0-5 volts, and the gate-to-source voltage of second, high voltage, MOS transistor 26 will normally swing between abbut 0-22 volts.

Referring now to FIG. 2, the equivalent schematic diagram of the structure of FIG. 1 shows first, low voltage, MOS transistor 14 having its gate connected to a source of gate voltage V_{g1}. The gate voltage V_{g1} may swing between V₀, a negative voltage source, and a positive voltage limited by the breakdown of the transistor. The source of transistor 14 is connected to positive voltage source V₁. The drain of first, low voltage, MOS transistor 14 may be connected to other circuitry (not shown).

Second, high voltage, MOS transistor 26 has its gate connected to a source of gate voltage V^{g2}. The gate voltage V_{g2} may swing between V₀ and a positive voltage limited by the breakdown of the transistor. The source of high voltage transistor 26 is connected to positive voltage source V₂, which is higher than V₁ and may be higher than the breakdown voltage of transistor 14. The drain of second, high voltage, MOS transistor 26 may be connected to other circuitry (not shown). The substrates of both transistors 14 and 26 are connected to voltage source V₂.

In a typical application, V₁ will be 5 volts, used for powering logic, and V₂ will be 20 volts, used for programming purposes on the semiconductor chip. If conventional MOS device and circuit design techniques are employed, the thickness of first gate dielectric 24 will usually be such that it cannot withstand a gate to source voltage of 20 volts. This would normally require that first, low voltage, MOS transistor 14 be fabricated in a separate well in order to protect its gate dielectric from damage.

By using the present invention, however, the thin gate dielectric 24 of first, low voltage, MOS transistor 14 is protected from the electric field of the well-to-gate potential difference by a depletion layer which is formed at the surface of the well 12. The surface potential at the gate region of first, low voltage, MOS transistor 14 is established at V₁ because its source 16 is connected to voltage source V₁. The depletion layer will drop most of the potential difference, limiting the voltage across the gate dielectric to approximately the gate-to-source voltage.

The operation of the present invention may be most easily seen with reference to FIG. 3, an enlarged portion of the cross section of FIG. 1 showing first, low voltage, MOS transistor 14 in more detail. It can be easily seen that the surface potential at the gate region of first, low voltage, MOS transistor 14 is established at V₁ because its source 16 is connected to voltage source V₁. Any excess holes entering the channel raise the potential difference between the channel and the source. This potential difference creates an electric field which draws holes out of the channel and into the source, thereby reducing the channel potential. The excess holes are attracted to negative potential. For example, if the gate is at zero volts, the source is at 5 volts, the well is at 20 volts, and the drain is at zero volts, the excess holes will be swept into the drain because the channel drain is at zero volts while the source is 5 volts. Having the source at 5 volts means that the surface potential cannot exceed 5 volts, but it can be less than 5 volts if the drain is below 5 volts. The source voltage (combined with the gate voltage) puts a worst-case limit on the low voltage oxide stress potential which is within operating limits. Depletion layer 46 will drop most of the potential difference between the bulk of the well and the gate of first, low voltage, MOS transistor 14, limiting the voltage across the gate dielectric to approximately its gate-to-source voltage.

## Claims

1. A semiconductor structure including:
a semiconductor substrate (10) of a first conductivity type;
a well structure (12) of a second conductivity type formed in said substrate;
a first low voltage MOS transistor (14) in said well including spaced-apart low voltage transistor source (16) and drain (18) regions of said first conductivity type in said well forming a first transistor channel region (20) therebetween, a first transistor gate (22) disposed above said first transistor channel region (20) and separated therefrom by a first transistor gate dielectric (24) having a first thickness, said low voltage transistor source region being connected to a source of low voltage;
a second high voltage transistor (26) in said well including spaced-apart high voltage source (28) and drain (30) regions of said first conductivity type in said well forming a second transistor channel (32) therebetween, a second transistor gate (34) disposed above said second transistor channel region (32) and separated therefrom by a second transistor gate dielectric (34) having a second thickness which is greater than the thickness of said first transistor gate dielectric, said high voltage source region (28) being connected to a source of high voltage;
first and second contact diffusions (38,40) of said second conductivity type located at the edge of said well and connected to said source of high voltage.

## Patentansprüche

1. Halbleiteranordnung, die enthält:
ein Halbleitersubstrat (10) eines ersten Leitungstyps;
eine Wannenstruktur (12) eines zweiten Leitungstyps, die in dem Substrat gebildet ist;
einen ersten Niederspannungs-MOS-Transistor (14) in der Wanne, der voneinander beabstandete Niederspannungstransistorsource- (16) und -drain-(18) -bereiche des ersten Leitungstyps in der Wanne hat, die zwischen sich einen ersten Transistorkanalbereich (20) bilden, und ein erstes Transistorgate (22), das über dem ersten Transistorkanalbereich (20) liegt und davon durch ein erstes Transistorgatedielektrikum (24) getrennt ist, das eine erste Dicke hat, wobei der Niederspannungstransistorsourcebereich mit einer Niederspannungsquelle verbunden ist;
einen zweiten Hochspannungstransistor (26) in der Wanne, der voneinander beabstandete Hochspannungssource-(28) und -drain- (30 -bereiche des ersten Leitungstyps in der Wanne hat, die zwischen sich einen zweiten Transistorkanal 32 bilden und ein zweites Transistorgate (34) enthält, das über dem zweiten Transistorkanalbereich (32) liegt und von diesem durch ein zweites Transistorgatedielektrikum (34) getrennt ist, welches eine Dicke hat, die größer ist als die Dicke des ersten Transistorgatedielektrikums, wobei der Hochspannungssourcebereich (28) mit einer Hochspannungsquelle verbunden ist;
erste und zweite Kontaktdiffusionen (38, 40) des zweiten Leitungstyps, die an der Kante der Wanne liegen und mit der Hochspannungsquelle verbunden sind.

## Revendications

1. Structure de semi-conducteur comprenant :
un substrat semi-conducteur (10) d'un premier type de conductivité ;
une structure de drain (12) d'un second type de conductivité, formée dans ledit substrat ;
un premier transistor MOS (semi-conducteur à grille isolée par oxyde métallique) à tension faible (14) dans ledit drain, comprenant une région source (16) et une région drain (18) de transistor à tension faible dudit premier type de conductivité, placées à distance l'une de l'autre dans ledit drain et formant entre elles une première région de canal de transistor (20), une première grille de transistor (22) disposée au-dessus de ladite première région de canal de transistor (20) et isolée de celle-ci par un premier diélectrique de grille de transistor (24) ayant une première épaisseur, ladite région source de transistor à tension faible étant reliée à une source de tension faible ;
un second transistor à haute tension (26) dans ledit drain, comprenant une région source (28) et une région drain (30) à haute tension dudit premier type de conductivité, placées à distance l'une de l'autre dans ledit drain et formant entre elles un second canal de transistor (32), une seconde grille de transistor (34) disposée au-dessus de ladite seconde région de canal de transistor (32) et isolée de celle-ci par un second diélectrique de grille de transistor (36) ayant une seconde épaisseur, supérieure à l'épaisseur dudit premier diélectrique de grille de transistor, ladite région source à haute tension (28) étant reliée à une source de haute tension ;
une première et une seconde régions de diffusion par contact (38, 40) dudit second type de conductivité, situées sur le bord dudit drain et reliées à ladite source de haute tension.
